(19) Europäisches Patentamt
European Patent Office
Office européen des brevets

(11) Veröffentlichungsnummer: **0 033 079**
**B1**

(12) # EUROPÄISCHE PATENTSCHRIFT

(45) Veröffentlichungstag der Patentschrift: **24.10.84**

(21) Anmeldenummer: **81100170.0**

(22) Anmeldetag: **13.01.81**

(51) Int. Cl.³: **C 09 D 3/80,** C 08 K 5/00, C 08 L 69/00, C 08 L 67/00, C 09 K 11/06, H 01 L 31/02, C 09 B 5/62

(54) **Neue Perylen-3,4,9,10-tetracarbonsäurediimide und deren Verwendung.**

(30) Priorität: **19.01.80 DE 3001857**
**19.01.80 DE 3001858**

(43) Veröffentlichungstag der Anmeldung: **05.08.81 Patentblatt 81/31**

(45) Bekanntmachung des Hinweises auf die Patenterteilung: **24.10.84 Patentblatt 84/43**

(84) Benannte Vertragsstaaten: **CH DE FR GB IT LI**

(56) Entgegenhaltungen:
**BE - A - 656 105**
**CH - A - 562 852**
**DE - A - 2 210 170**
**DE - A - 2 851 513**
**FR - A - 2 148 510**
**FR - A - 2 153 350**
**FR - E - 78 658**
**GB - A - 2 019 026**

**Die Akte enthält technische Angaben, die nach dem Eingang der Anmeldung eingereicht wurden und die nicht in dieser Patentschrift enthalten sind.**

(73) Patentinhaber: **BASF Aktiengesellschaft, Carl-Bosch-Strasse 38, D-6700 Ludwigshafen (DE)**

(72) Erfinder: **Graser, Fritz, Dr., Blieskasteler Strasse 17, D-6700 Ludwigshafen (DE)**
Erfinder: **Seybold, Guenther, Dr., Friedrich-Ebert-Strasse 14, D-6701 Neuhofen (DE)**

**EP 0 033 079 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft neue Perylen-3,4,9,10-tetracarbonsäurediimide und deren Verwendung.

Aus den DE-A 2 620 115 und 2 554 226 sind Vorrichtungen bekannt, in denen sichtbares Licht in einer Kunststoffplatte durch eingelagerte Fluoreszenzzentren auf eine kleine Fläche konzentriert werden kann.

Die in diesen Vorrichtungen als Fluoreszenzzentren benötigten Verbindungen müssen insbesondere im Falle der Umwandlung von Lichtenergie in elektrische Energie eine hohe Lichtechtheit aufweisen, damit die Vorrichtungen eine für die Anwendung ausreichende Lebensdauer aufweisen. Das heisst, die als Fluoreszenzzentren verwendeten Verbindungen müssen in den verwendeten Kunststoffen eine hohe Lichtechtheit aufweisen.

Aufgabe der vorliegenden Erfindung war es, für die bekannten Vorrichtungen zur Lichtkonzentrierung als Fluoreszenzzentren geeignete Verbindungen bereitzustellen, die eine hohe Fluoreszenz bei gleichzeitig hoher Lichtechtheit in dem verwendeten Medium aufweisen und die auf das Medium keine nachteilige Wirkung ausüben.

Gegenstand der Erfindung sind neue Perylen-3,4,9,10-tetracarbonsäurediimide der Formel

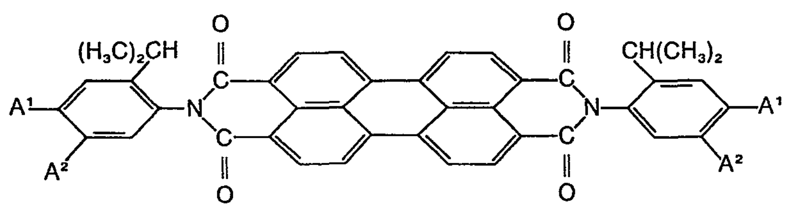

(I),

in der $A^1$ Isopropyl und $A^2$ Wasserstoff oder $A^2$ Isopropyl und $A^1$ Wasserstoff bedeuten. Die Farbstoffe zeichnen sich durch sehr gute Echtheitseigenschaften aus.

Die neuen Farbstoffe der Formel I eignen sich ausgezeichnet zum Einfärben von Kunststoffen, insbesondere von thermoplastischen Kunststoffen in der Masse. Sie liefern sehr klare, leuchtende, fluoreszierende orange Färbungen, die eine sehr gute Lichtechtheit aufweisen. Die Farbstoffe lassen sich auch im Gemisch mit anderen Farbstoffen zum Einfärben von Kunststoffen verwenden, wobei sehr klare, brillante Färbungen erhalten werden. Die neuen Farbstoffe sind ausserdem hervorragend zur Herstellung von in der DE-A 2 620 115 beschriebenen Kunststoffplatten zur Konzentrierung von Licht geeignet, wobei die neuen Farbstoffe als Fluoreszenzzentren dienen. Die Verbindungen der Formel I sind in den Kunststoffen, aus denen die für die Lichtkonzentrierung verwendeten Kunststoffplatten hergestellt werden, sehr lichtecht und wandeln eingestrahltes Licht in hoher Ausbeute in Fluoreszenzlicht um. Die Wellenlänge des ausgestrahlten Fluoreszenzlichts liegt zwischen 500 und 600 nm.

Die neuen Farbstoffe der Formel I können in an sich bekannter Weise durch Kondensation von Perylen-3,4,9,10-tetracarbonsäure oder deren Anhydrid mit 2,4-Diisopropyl- oder 2,5-Diisopropylanilin in Lösungs- oder Verdünnungsmitteln, wie Chinolin, Naphthalin oder Trichlorbenzol, oder in einem Überschuss der Anilinverbindung bei höherer Temperatur, beispielsweise bei Temperaturen zwischen 180 und 230 °C hergestellt werden. Die Umsetzung führt man zweckmässigerweise in Gegenwart von Mitteln durch, welche die Kondensation beschleunigen, z. B. von Zinkchlorid, Zinkacetat, Zinkpropionat oder Salzsäure.

Aus dem Reaktionsgemisch isoliert man die Farbstoffe in üblicher Weise, beispielsweise durch Filtration. Vorteilhafterweise erfolgt die Filtration bei höheren Temperaturen, wie 80 bis 120 °C, gegebenenfalls nach dem Verdünnen des Reaktionsgemisches mit inerten Lösungsmitteln, z. B. mit niederen Carbonsäureamiden, wie Formamid, aromatischen Lösungsmitteln, wie Toluol oder Chlorbenzol, oder vorzugsweise Alkoholen, wie Methanol, Äthanol oder Isobutanol.

Zur Entfernung etwa noch vorhandener Spuren an Perylen-3,4,9,10-tetracarbonsäure kann man die Farbstoffe mit verdünnter Natronlauge oder Sodalösung auskochen.

Die Farbstoffe werden gegebenenfalls noch weiter gereinigt, z. B. durch fraktionierte Fällung aus konzentrierter Schwefelsäure, durch Umkristallisieren aus hochsiedenden, leicht entfernbaren Lösungsmitteln oder durch Auskochen mit Lösungsmitteln unter Mahlbedingungen. Gegebenenfalls wird das Reinigungsverfahren ein- oder mehrfach wiederholt oder es werden verschiedene Reinigungsverfahren kombiniert, um sehr reine Verbindungen (I) zu erhalten.

Zur Anwendung für die Lichtkonzentration werden die Verbindungen (I) in für die Anwendung geeigneten Kunststoffen eingearbeitet. Hierzu wird der Kunststoff als Granulat mit der benötigten Menge an (I) bepudert und die Granulate dann zu Flächengebilden extrudiert. Als Kunststoffe (Medium) kommen z. B. für eine Verwendung zur Lichtkonzentration für Solarzellen vorzugsweise Polymethylmethacrylat, Polymethylacrylat, Polystyrol, Polydiäthylenglykol-diallylbiscarbonat, ferner auch geeignete Polyamide und Polycarbonate in Betracht.

Die Erfindung soll durch die folgenden Beispiele weiter erläutert werden. Die im folgenden angegebenen Teile und Prozentangaben beziehen sich auf das Gewicht.

Beispiel 1

1000 Teile Polymethylacrylatgranulat werden mit 0,05 Teilen des Farbstoffs der Formel

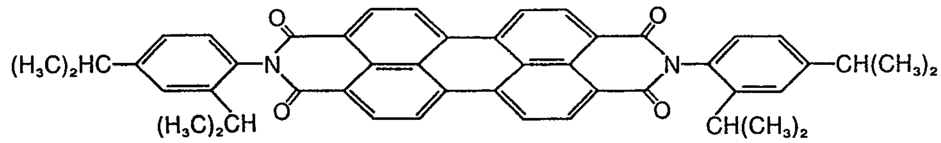

gleichmässig bepudert. Die Mischung wird anschliessend zu Platten extrudiert.

Beispiel 2

Entsprechend den Angaben in Beispiel 1 wurden mit dem gleichen Farbstoff Fluoreszenzplatten aus Polymethylmethacrylat hergestellt.

Beispiel 3

In 840 Teilen Chinolin werden bei 100 °C 40,8 Teile kristallisiertes Zinkacetat, 117 Teile Perylentetracarbonsäure und 135 Teile 2,4-Diisopropylanilin eingetragen. Unter Überleiten eines schwachen Stickstoffstromes erhitzt man auf 225 bis 230 °C und hält bei dieser Temperatur, bis eine aufgearbeitete Probe, mit verdünnter Sodalösung aufgekocht, keine Perylentetracarbonsäure mehr anzeigt. Dies ist nach etwa 2 Stunden der Fall. Nach dem Abkühlen auf etwa 100 °C wird filtriert, mit Chinolin, dann mit Methanol und anschliessend mit Wasser gewaschen. Das Filtergut rührt man mit etwa 1200 Teilen 2%iger wässriger Sodalösung an, erhitzt auf etwa 95 °C, filtriert und wäscht neutral. Spuren möglicherweise noch vorhandener Perylentetracarbonsäure werden dabei entfernt. Nach dem Trocknen erhält man den Farbstoff mit sehr guter Ausbeute.

Verfährt man wie vorstehend angegeben, verwendet jedoch anstelle des 2,4-Diisopropylanilins die gleiche Menge 2,5-Diisopropylanilin, so erhält man in sehr guten Ausbeuten Perylentetracarbonsäure-N,N′-bis-(2′,5′-diisopropylanilid).

Beispiel 4

Kunststoffeinfärbung:

0,05 Teile Perylen-3,4,9,10-tetracarbonsäure-bis-(2′,4′-diisopropylanilid) werden in einem Schnellmischer mit 100 Teilen gemahlenem Polystyrol-Blockpolymerisat trocken gemischt. Das Gemisch wird auf einer Schneckenpresse bei einer Zylindertemperatur von 200 bis 250 °C geschmolzen und homogenisiert. Die gefärbte plastische Masse wird durch Heissabschlagen am Düsenkopf oder durch Ausziehen von Fäden unter Kühlung granuliert. Das so erhaltene Granulat wird anschliessend in einer Spritzgussvorrichtung bei 200 bis 250 °C zu Formkörpern verspritzt oder auf Pressen zu beliebigen Körpern verpresst. Man erhält leuchtend orangefarbene Spritzlinge oder Presslinge, die fluoreszieren und sehr gute Lichtechtheit aufweisen.

Anstelle von Polystyrol-Blockpolymerisat kann auch ein Polystyrol-Emulsionspolymerisat, ein Suspensionspolymerisat oder ein Mischpolymerisat von Styrol mit Butadien und Acrylnitril oder Acrylestern verwendet werden.

Ganz ähnliche Färbungen mit praktisch den gleichen Eigenschaften erhält man, wenn man anstelle des Perylen-3,4,9,10-tetracarbonsäure-N,N′-bis-(2′,4′-diisopropylanilids) das Perylen-3,4,9,10-tetracarbonsäure-N,N′-bis-(2′,5′-diisopropylanilid) verwendet.

**Patentansprüche**

1. Perylen-3,4,9,10-tetracarbonsäurediimid-Farbstoffe der Formel

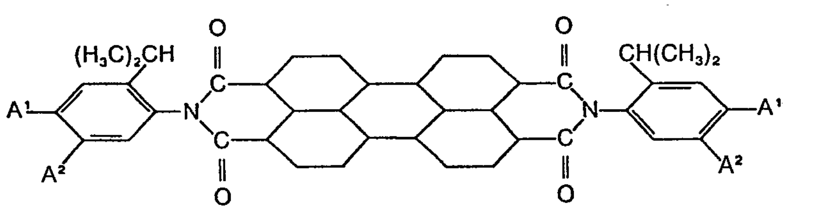

,

in der $A^1$ Isopropyl und $A^2$ Wasserstoff oder $A^2$ Isopropyl und $A^1$ Wasserstoff bedeuten.

2. Farbstoffe gemäss Anspruch 1, dadurch gekennzeichnet, dass in der Formel $A^1$ für Isopropyl und $A^2$ für Wasserstoff stehen.

3. Verwendung der Farbstoffe gemäss den Ansprüchen 1 oder 2 zum Färben von Kunststoffen in der Masse.

**Claims**

1. A perylene-3,4,9,10-tetracarboxylic acid diimide dye of the formula

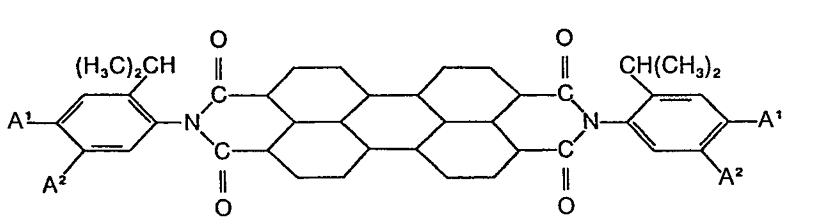

where $A^1$ is isopropyl and $A^2$ is hydrogen, or $A^2$ is isopropyl and $A^1$ is hydrogen.

2. A dye as claimed in claim 1, in the formula of which $A^1$ is isopropyl and $A^2$ is hydrogen.

3. The use of a dye as claimed in claim 1 or 2 for the mass coloration of plastics.

**Revendications**

1. Colorants de diimide d'acide pérylène-3,4,9,10-tétracarboxylique de formule

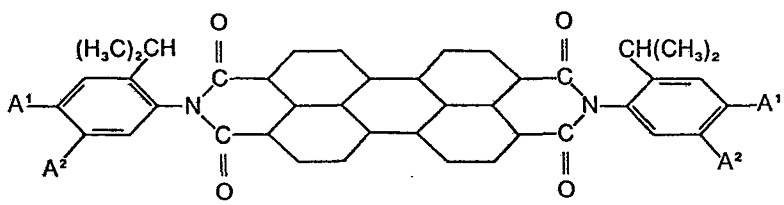

dans laquelle $A^1$ est mis pour un groupe isopropyle et $A^2$ pour un hydrogène ou $A^2$ est mis pour un groupe isopropyle et $A^1$ pour un hydrogène.

2. Colorants selon la revendication 1, caractérisés en ce que, dans la formule, $A^1$ est mis pour un groupe isopropyle et $A^2$ pour un hydrogène.

3. Utilisation des colorants selon la revendication 1 ou 2 pour la coloration de matières synthétiques dans la masse.